# EUROPEAN PATENT APPLICATION

(11) **EP 2 790 137 A1**
(43) Date of publication of application: **15.10.2014**
(21) Application number: 14158282.5
(22) Date of filing: 07.03.2014
(51) Int. Cl.: G06Q 10/06

(54) **Managing a model having an object cycle**

(30) Priority: 11.04.2013 US 201313860676
(71) Applicant: The Boeing Company, Chicago, IL 60606-2016 (US)
(72) Inventor: Kelsey, William D., Chicago, IL 60606-2016 (US); Jones, David H., Chicago, IL 60606-2016 (US)
(74) Representative: Smith, Jeremy Robert

(57) **Abstract**

A model-management system (400) includes a cycles map generator (806), object registry generator (810) and runtime code generator (816). The cycles map generator (806) is configured to create a cycles map (808) that, for a cycle in an information model having a plurality of objects, identifies a non-dominant association of a second or later object to a first object. The object registry generator (810) is configured to create an object registry map (812). And the runtime code generator (816) is configured to generate an instantiable information model and object registry (904) based on the information model and maps. Generation of the instantiable information model includes generation of a plurality of instantiable objects (902) including a second /later instantiable object that, for the non-dominant association, includes an object qualifier that identifies a referenced object for the first object to be instantiated through the object registry (904), instead of a contained first instantiable object to be instantiated from within the second /later instantiable object.

## Description

### TECHNOLOGICAL FIELD

The present disclosure relates generally to model-driven engineering and, in particular, to managing a model having an object cycle.

### BACKGROUND

Information models, sometimes referred to herein as data models, are increasingly utilized in design and manufacture of a wide variety of products, structures and facilities. As the complexity and variants of a particular product, structure or facility design increase, such modeling can provide numerous benefits including facilitating design and manufacturing efficiency.

For example, highly-complex products, structures or facilities like aircraft, ships, off-shore oil-drilling platforms, electrical-distribution systems, computer-software systems, computational genomic structures and the like are typically constructed using hundreds or thousands of assemblies, which in turn include numerous individual components or sub-assemblies. Collecting and managing data about such assemblies in the form of data models facilitates streamlining the design and manufacturing process of the product, structure or facility. Having such data also facilitates designing variants, improvements and additional subsystems.

In addition, capturing such data facilitates a virtual product designing process, which may include designing and testing a product in a virtual environment (e.g., on a computer), and the automatic generation of computer-readable program code that may be executed to simulate the product. Virtual product designing often facilitates reducing highly-expensive physical prototyping and testing of the product. Virtual product design environments can save significant costs and time required for designing a given product, machine or facility.

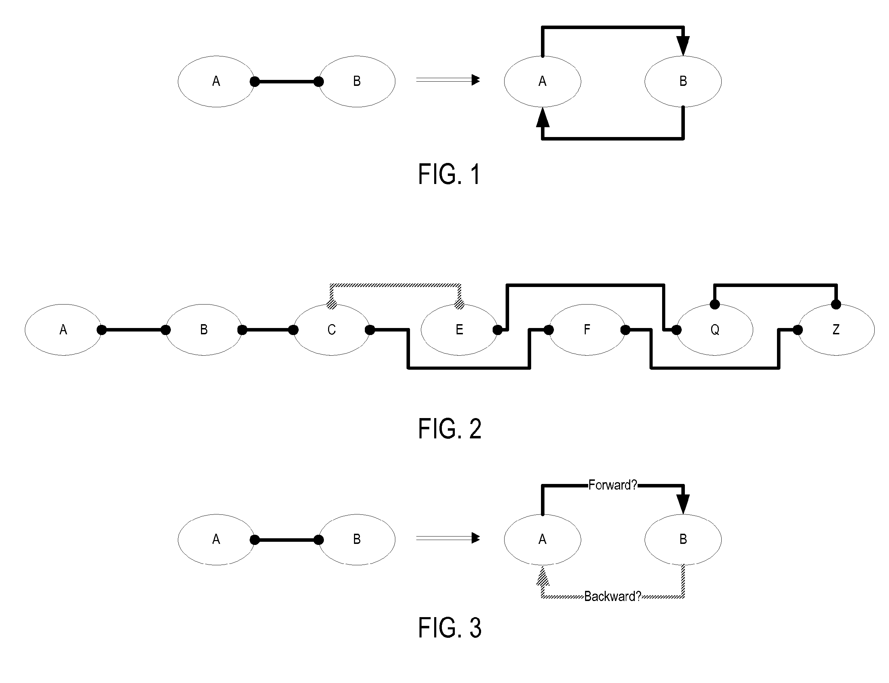

An information model may describe a product and its components using object-oriented techniques. The model may include numerous model objects and describe information relationships supporting exchange of not only information sets, but also their interrelationships. An information model may be expressed as a directed graph where, for automatic code generation purposes, the graph must contain no cycles between nodes (objects). As shown in FIGS. 1 and 2, a rich information model often contains simple (A=>B=>A, where A and B are objects) and/or complex
(A=>B=>C=>F=>Z=>Q=>E=>C, where A, B, C, F, Z, Q and E are objects) circular references. FIG. 3 illustrates breaking a directed graph cycle between the objects of FIG. 1. The resultant graph with cycles removed is considered a directed acyclic graph (DAG).

Targeted, implementation-specific solutions for generating a DAG have historically been applied to allow for runtime software objects containing these cycles. When automated code-generation tools are used to create object interface definitions (e.g., IDL), cycles appear in generated instantiable objects. Existing solutions require removal of cycles within the model - losing the inherent richness of model and expressivity in the implemented data objects or custom rework of the automatically-generated instantiable objects to remove cycles in the historical manner for the targeted language.

### BRIEF SUMMARY

Example implementations of the present disclosure address issues related to computer-readable program code generation based on models with cycles, and are generally directed to a system, and corresponding method and computer-readable storage medium for managing a model having an object cycle. Model object associations are currently either discarded or require extensive customization to incorporate in the runtime code. Example implementations of the present disclosure provide a compromise between preservation of rich model relationships and instantiable code; not only preserving these associations in an automated fashion, but also providing a means for portability among platforms and languages. Example implementations may apply a language-independent technique, which may in turn provide a mechanism to port a generated interface to multiple platforms and compilers.

Auto-generation of code from information models may provide a significant time savings. Information models may be implemented across a broad spectrum of categories, such as the design of products, structures or facilities (generally "products") like aircraft, ships, off-shore oil-drilling platforms, electrical-distribution systems, computer-software systems, computational genomic structures and the like. The information models may be generated with interfaces that make products and services highly interoperable with partners, suppliers and competitors in a wide variety of industries and technical sectors. In the context of electrical-distribution, example implementations of the present disclosure may be utilized to provide data protocol translation and data/information management related to the instrumentation, sensors, data acquisition and the like on an electric grid. Similarly, example implementations may provide a common operating environment for electrical-distribution projects for utility transmission and distribution customers. Other example use cases include examination of electrical power quality, maintenance, facilities management, distributed energy (micro-grid operation and forward planning), federated system management, electric storage, demand response, advanced metering, electrical power transportation, distribution management and micro-grid design and the like.

According to one aspect of example implementations, a model-management system is provided that includes a cycles map generator, object registry generator and runtime code generator. The cycles map generator configured to traverse an information model having a plurality of objects at least some of which form a cycle. The cycles map generator is also configured to create a cycles map that, for the cycle, identifies a non-dominant association of a second or later object to a first object. The object registry generator is configured to create an object registry map that identifies the non-dominant association and includes one or more lifecycle policies for a second or later instantiable object for the respective second or later object.

The runtime code generator is configured to generate an instantiable information model and object registry based on the information model, cycles map and object registry map. Generation of the instantiable information model includes generation of a plurality of instantiable objects for respective ones of the objects of the information model. This includes generation of the second or later instantiable object that, for the non-dominant association, includes an object qualifier that identifies a referenced object for the first object to be instantiated through the object registry, instead of a contained first instantiable object to be instantiated from within the second or later instantiable object. In one example, the runtime code generator is configured to generate the second or later instantiable object including the contained first instantiable object, and then remove the contained first instantiable object and replace it with the object qualifier.

In one example, the model-management system further includes a model repository configured to store one or more information models at least some of which are removable according to a weighted first-in-first-out technique. In this example, the cycles map generator may be configured to receive the information model from the model repository.

In one example, the model-management system further includes an adapter component configured to convert the information model from any of a plurality of different formats to a common format in which the information model is traversed.

In one example, the runtime code generator is configured to generate the instantiable information model using a plurality of object-oriented design patterns including a proxy pattern and factory method pattern. In this example, the object registry generated by the runtime code generator may include an object manager configured to implement the proxy pattern to manage instantiation of the referenced object, and an object factory configured to implement the factory method pattern to instantiate the referenced object. In a further example, the object-oriented design patterns may also include a singleton pattern, and the object factory may be configured to implement the factory method pattern according to the singleton pattern to restrict instances of the referenced pattern according to a cardinality value.

In one example, the first object is related to the second object through a dominant association, and the second or later object is related back to the first object through the non-dominant association. In this example, generation of the instantiable objects may include generation of the first instantiable object that, for the dominant association, contains the second instantiable object for instantiation from therewithin.

In other aspects of example implementations, a method and computer-readable storage medium are provided for managing a model having an object cycle. A computer-readable storage medium is provided that includes computer-readable program code portions stored therein. The computer-readable program code, in response to execution by a processor, causes an apparatus to at least traverse an information model having a plurality of objects at least some of which form a cycle, and create a cycles map (808) that, for the cycle, identifies a non-dominant association of a second or later object to a first object, and create an object registry map (812) that identifies the non-dominant association and includes one or more lifecycle policies for a second or later instantiable object for the respective second or later object. The computer-readable program code further causes an apparatus to generate an instantiable information model and object registry (904) based on the information model, cycles map (808) and object registry map (812). Then generation of the instantiable information model includes generation of a plurality of instantiable objects (902) for respective ones of the objects of the information model, including generation of the second or later instantiable object that, for the non-dominant association, includes an object qualifier that identifies a referenced object for the first object to be instantiated through the object registry (904), instead of a contained first instantiable object to be instantiated from within the second or later instantiable object. The features, functions and advantages discussed herein may be achieved independently in various example implementations or may be combined in yet other example implementations further details of which may be seen with reference to the following description and drawings.

### BRIEF DESCRIPTION OF THE DRAWING(S)

Having thus described example implementations of the disclosure in general terms, reference will now be made to the accompanying drawings, which are not necessarily drawn to scale, and wherein:
FIG. 1 illustrates a circular object reference from a bi-directional association between two objects of a model;
FIG. 2 illustrates a second-order cycle from bi-directional associations between objects of a model;
FIG. 3 illustrates breaking a directed graph cycle between the two objects of FIG. 1;
FIG. 4 illustrates a model-management system according to one example implementation;
FIG. 5 illustrates a leveled node object registry according to one example implementation;
FIGS. 6 and 7 illustrate two example scenarios in leveling a cyclic node, according to one example implementation;
FIG. 8 illustrates a code-generation system according to one example implementation; and
FIG. 9 illustrates runtime model artifacts generated according to one example implementation.

### DETAILED DESCRIPTION

Some implementations of the present disclosure will now be described more fully hereinafter with reference to the accompanying drawings, in which some, but not all implementations of the disclosure are shown. Indeed, various implementations of the disclosure may be embodied in many different forms and should not be construed as limited to the implementations set forth herein; rather, these example implementations are provided so that this disclosure will be thorough and complete, and will fully convey the scope of the disclosure to those skilled in the art. For example, unless otherwise indicated, reference something as being a first, second, third or the like should not be construed to imply a particular order, nor should the nomenclature "A," "B," "C" or the like. Also, something may be described as being above something else (unless otherwise indicated) may instead be below, and vice versa; and similarly, something described as being to the left of something else may instead be to the right, and vice versa. Like reference numerals refer to like elements throughout.

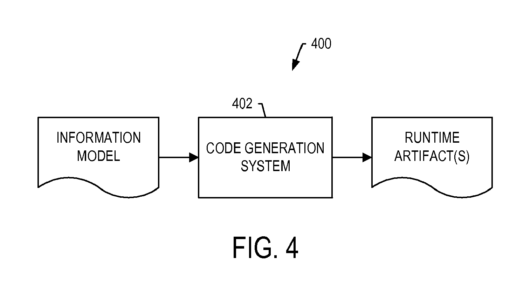

Referring now to FIG. 4, a model-management system **400** is illustrated according to example implementations of the present disclosure. The system may include any of a number of different subsystems (each an individual system) for performing one or more functions or operations. As shown, for example, the system may include a code-generation system **402** generally configured to receive an information model for a product, and automatically generate one or more runtime model artifacts. In various examples, the model may be for a physical or non-physical product such as aircraft, ships, off-shore oil-drilling platforms, electrical-distribution systems, computer-software systems, computational genomic structures and the like. The product may be generally composed of a plurality of systems, subsystems, assemblies, subassemblies, components, parts or the like (each generally a "component"). The model may include a functional description of the product and its components in terms of a hierarchical breakdown of nodes, and may reflect functional relationships or associations between various components by connections or associations between nodes. In one example, then, the runtime model artifacts may include computer-readable program code that may be executed (machine code) or compiled for execution (source code) in a virtual environment (e.g., on a computer), such as to enable one to study interactions between the components during design of the product.

In various example implementations, the model may describe the product and its components using object-oriented techniques. Thus, the model may include objects for respective components of the product, and may include an object representative of functional performance of a product. The runtime model artifacts may include computer-readable program code, which may in turn include instantiable objects for respective objects of the model. An information model may therefore describe a product, and include a plurality of "model objects" (or simply "objects") that describe discrete physical components or processes of the product. And an "instantiable object" may refer to a software object representative of the respective physical component or process of the product.

As suggested above, various objects (nodes) of the model may be related through associations between the respective objects. In various examples, the association of one object to another object may be reflected in their respective instantiable objects. The instantiable object for the one object may contain the instantiable object for the other object (the contained instantiable object at times simply referred to as a "containment object"). That is, the association of one object to another may be reflected in the instantiable object for the one object containing the instantiable object for the other object. In this structure, the one instantiable object may be considered a parent to the containment object, which may be instantiated from within its parent. For example, in an instance in which a model contains a cycle with the associations A=>B and B=>A, the following instantiable objects may be generated:

```
       A
      public A() {//constructor}
             B bInstanceObject = new B()
       B
       Public B() {//constructor}
             A aInstanceObject = new A();
```

In the preceding, bInstanceObject and aInstanceObject may be considered containment objects, each of which may be instantiated from within is respective parent A and B.

In various instances, an information model may include one or more cycles. Each cycle may in turn include a sequence of two or more related objects at least one of which refers to (references) another object, and is referred back to by the same other object (e.g., FIG. 1) or a further object (e.g., FIG. 2). In the cycle, a first object may be related to a second object through a forward-facing, dominant association. The second or a later (e.g., third) object, then, may be related back to the first object through a backward-facing, non-dominant association. For instance, consider a cycle in which an object A refers to another object B that refers back to object A. In this instance, A=>B (object A referring to object B) may describe the dominant association, while B=>A (object B referring to object A) may describe the non-dominant association. In various examples, the non-dominant association (e.g., B=>A) may be considered an inverse relationship, and the referenced object (e.g., object A) may be considered the inverse object (node). And as suggested above, the terms "first," "second," "third" and the like should not be taken as implying a particular order of the respective objects within the code.

As explained in the background section, existing solutions for automating code generation for an information model require removal of any cycles within the model. Similarly, the code-generation system **402** of example implementations may be configured to identify any cycles in the information model, and in each such instance, determine the dominant association that may be persisted in the generated code. But rather than "throw out" the non-dominant association, the code-generation system of example implementations may capture and re-introduced the relationship through one or more object properties that may be used as keys to access the relationship through a proxy.

In accordance with example implementations, the code-generation system **402** may flatten or otherwise level an information model's objects in order to maintain rich object relationships, while still automatically generating appropriate computer-readable program code. As suggested above, a cycle may include a first object (e.g., object A) related to a second object (e.g., object B) through a dominant association, with the second object or a later object being related back to the first object through a non-dominant association. And the generated code (instantiable information model) may include instantiable first and second objects for respective ones of the first and second objects, and perhaps also a later instantiable object for the later object.

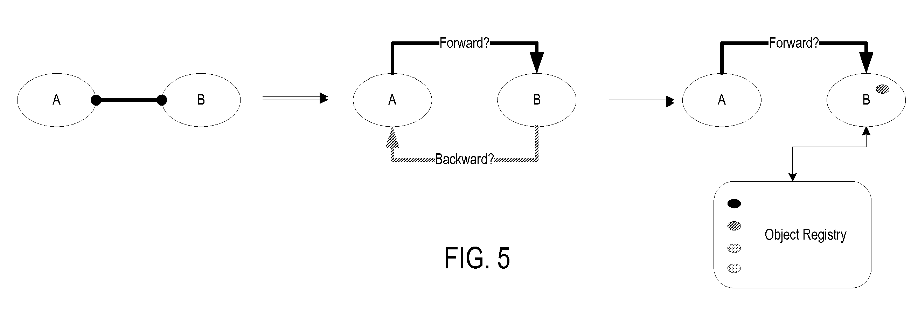

As shown for example in FIG. 5, the dominant association may be persisted in the generated code through containment of the second instantiable object by the first instantiable object for instantiation from therewithin. But for the non-dominant association, the second or later instantiable object may include an object qualifier that identifies a referenced instantiable object (or simply "referenced object") for the first object, instead of the first instantiable object contained by the second or later instantiable object. The object qualifier, then, may be used as a key to access the referenced object through a shared object registry at runtime. The referenced object may correspond to the first instantiable object, but may be instantiated through the object registry instead of within the second or later instantiable object (its parent). Example implementations of the present disclosure may be more particularly described in the context of the code-generation system **402** being configured to generate the second/later instantiable object with the containment object for the first object, and then remove the respective containment object from the second/later instantiable object and replace it with the object qualifier. In the above example, given the non-dominant association B=>A, the containment object aInstanceObject may be removed and replaced with an object qualifier. It should be understood, however, that the code-generation system may be equally configured to simply generate the second/later instantiable object with the object qualifier instead of the containment object for the first object.

The object qualifier may be structured in any of a number of different manners. For example, the object qualifier include a JavaScript object notation (JSON) formatted string including the fully-qualified referenced object, fully-qualified containment object name and their cardinality. In one example, the object qualifier may uniquely identify the referenced object by a unique identifier (UID), such as a new global UID (GUID) property (e.g., the simplest of which may be the class name itself), which may be used for access within the shared object registry.

The code-generation system **402** may establish the object registry to contain object UIDs for runtime instantiation through a proxy based on object qualifiers. In various examples, the code-generation system may accomplish this using any of a number of object-oriented design patterns such as the registry pattern, proxy pattern, factory method pattern, singleton pattern and the like. The registry pattern defines an object (registry) that other objects may use to access data, settings, values and other objects. The proxy pattern forces method calls to an object to occur indirectly through a proxy object that acts as a surrogate for the other object, delegating method calls to that object. The factory method pattern defines a factory for creating an object that lets the classes that implement it decide which class to instantiate, and may allow a class to defer instantiation to subclasses. And the singleton pattern restricts the instantiation of a class to one object.

Object definitions may include a UID and a registry accessor (containing a proxy delegate conforming to a factory method, e.g., using a singleton based on cardinality) to permit a circular reference through the opaque reference of the inverse object. In addition to generating object interface definitions, the code-generation system 402 may create an object registry including a proxy to facilitate access to the referenced objects. Under this approach, containment objects for non-dominant associations (inverse objects) may be removed and replaced with an object qualifier that uniquely identifies the respective containment objects (e.g., by class reference). The object registry and proxy, then, may allow for the instantiation of these referenced objects.

The factory-method-based technique of example implementations may eliminate cyclic references preventing class instantiation based on instantiation of the referenced object in the constructor of the containment class. For illustrative purposes, where one class ("A") contains an object reference of another class ("B"), and class B contains an object reference of class A (bi-directional association without an explicit dominant direction), and each class instantiates its object references in its constructor, a memory leak may result. To avoid this, class A may contain GUID and cardinality basic type member variables, and a basic type object qualifier member variable, which may provide the aforementioned registry accessor for use by the object registry to instantiate it. The object registry may therefore break the cyclic nature generated by the association created in the object model, while maintaining the relationship between objects.

When the cardinality value is set, the object registry may maintain a multiplicity of associated objects. The cardinality may determine how many instances of a containment object may exist. For example, a 1:1 association may restrict instantion to one instance, whereas a 1:3 association may allow for three separate instances at runtime.

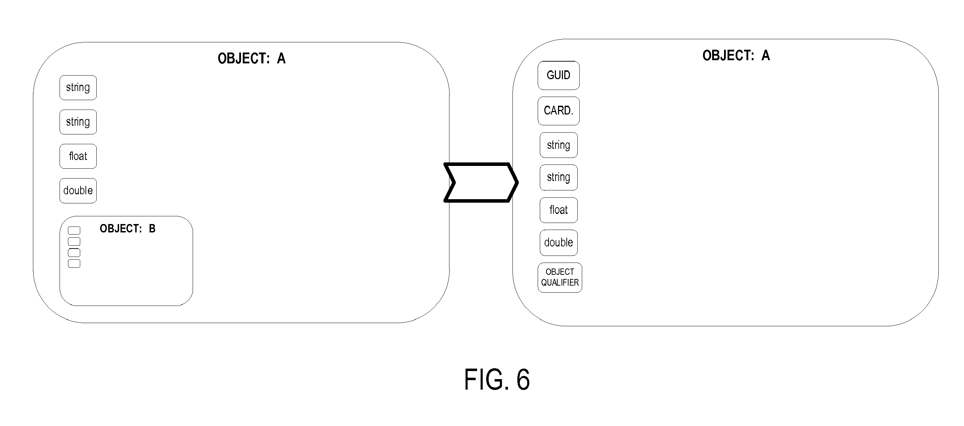

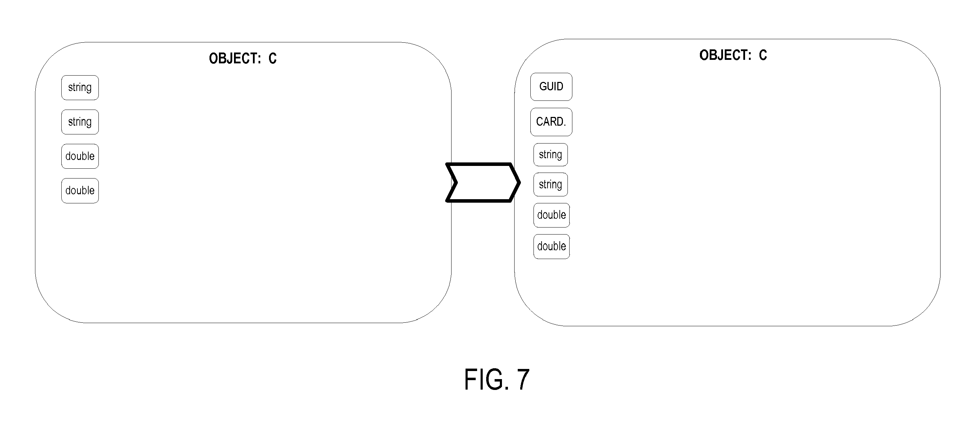

FIGS. 6 and 7 represent two example scenarios. FIG. 6 illustrates an instance in which an instantiable object A contains a containment object B, and which the code-generation system **402** may process to remove the containment object and apply a GUID, cardinality and object qualifier. FIG. 7 illustrates an instance in which an instantiable object C does not possess a containment object, and which the code-generation system may therefore process to apply a GUID and cardinality but without an object qualifier. In various examples, this processing may be for the case in which the containment object or one of its children contains an inverse relationship. It may manifest as object B possessing an object A member, or it may be more complex (e.g., A=>B=>E=>G=>D=>A) and/or multipath (e.g., A=>B=>C=>A and
A=>B=>D=>E=>G=>C=>A).

In existing solutions, the richness of model object associations is often either discarded or requires extensive, manual customization to incorporate in the runtime code. The approach of example implementations may provide a compromise between preservation of rich model relationships and instantiable code, which may not only preserve these associations in an automated fashion, but also provide a means for portability amongst platforms and languages. The approach may provide a mechanism to maintain the richness of object model associations at runtime, while avoiding at least some of the drawbacks of cyclic references. And as an added benefit, the language-independent technique may provide a mechanism to port a generated interface to multiple platforms and compilers.

In examples employing the registry pattern, an insidious garbage collection may develop in instances in which automated software-generation is implemented in a language such as Java. In these instances, if a stack grows and then shrinks, the objects popped off the stack (and any objects referenced by this obsolete object) may not get garbage collected even when they are no longer referenced, which may be due the stack maintaining obsolete references to these objects. To address this in Java implementations, the object registry may null these objects to avoid unintentional object retention.

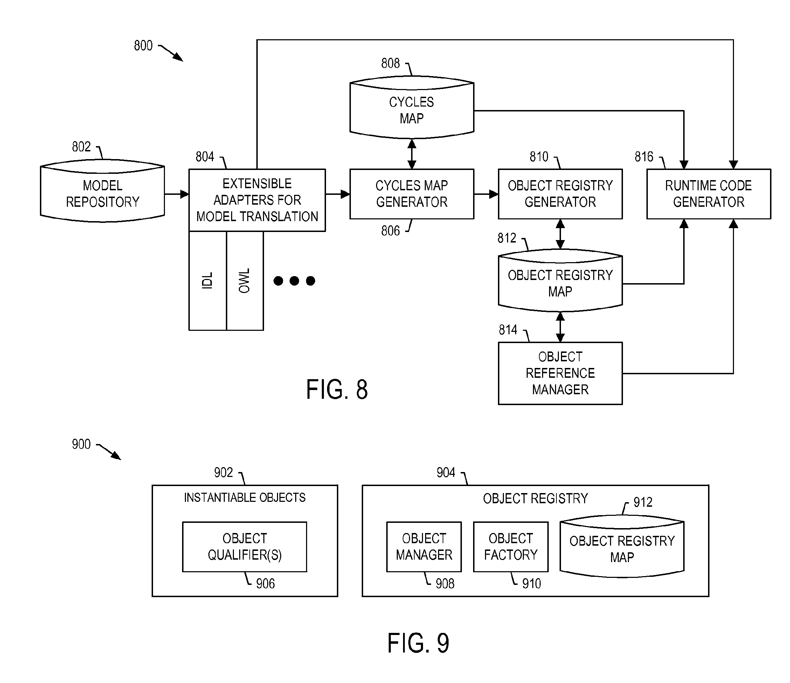

FIG. 8 illustrates a code-generation system **800** that in one example may correspond to the code-generation system **402** of FIG. 4. The code-generation system may be generally configured to automatically generate an instantiable information model from its electronic representation. As shown, the code-generation system may include a model repository **802,** an adapter component **804,** runtime cycles map generator **806** and associated runtime cycles map **808,** object registry generator **810** and associated object registry map **812,** and an object reference manager **814.** As also shown, the code-generation system may include a runtime code generator **816.**

The model repository **802** may be configured to store one or more information models for one or more products, which may be marked for persistence but also removable from the repository. In one example, a model may be removed in response to an overt user direct command to remove a stale persistent model. In another example, a model may be removed upon its expiration, such as in a weighted first-in-first-out (FIFO) technique based on resource consumption level, which may be configurable by a system administrator. Weighting for expiration of models may be a multivariate. Additional weightings may be provided based on model usage (frequency and date) and model size. And further weightings may be added, such as using standard minimum rules (SMR) syntax (algebraic).

The adapter component **804** may be configured to implement one or more extensible adapters for model translation, and may thereby convert information models in a plurality of different formats to a common format for processing. These formats may include, for example, interface description language (IDL), web ontology language (OWL) and the like, any one of which may be used as the common format (e.g., IDL). In this regard, the adapter component may provide an extendable approach for ingestion of models of various types and formats, and the creation of source code for differing target compilers and runtimes.

As indicated above, a model may include a functional description of a product and its components in terms of a hierarchical breakdown, and may reflect functional relationships or associations between various components. Once converted to a common format, then, the cycles map generator **806** may traverse the model hierarchy, and identify any cycles within the model. The cycles map generator may determine the dominant association for each cycle that may be persisted in the later-generated runtime model artifacts, or the non-dominant association that may be removed. In some instances, the cycles map generator may be configured to identify a directed object reference, which may indicate the dominant association (and thereby the non-dominant association). In other instances, object references may be derived from a non-directional (bi-directional) association, which may require additional attributes or properties, such as cardinality, to derive the dominant / non-dominant association. For example, in a one-to-many association (e.g., "one" A object that may be associated with "many" B objects), the A=>B association may be considered the dominant association.

In yet other instances, the dominant / non-dominant association may be non-determinate and all bi-directional object relationships may be desired to be persisted. In these instances, any number of different approaches may be taken. In accordance with one approach, an assignment may be made based on general factors such as object "popularity" (e.g., number of connections or associations between objects) and object complexity (e.g., the less popular/complex object may be taken as the inverse object). Object complexity may be determined by the number and size of object properties and associations. Using this approach, the most popular object (e.g., the one with the most associations) may be deemed the dominant object (i.e., the object associated with the inverse object in a non-dominant association), with node complexity providing a secondary weighting that may be used when popularity is non-determinant. This may be tailored to a domain using a set of programmable rules, as sometimes there may be domain-specific properties that may assist with determination of dominance (e.g., presence of a property such as serial number, grounding a physical asset as dominant, and therefore the source of the dominant / non-dominant association).

In accordance with another approach, or in instances in which the above approach fails to identify the dominant / non-dominant association, the respective association may be randomly assigned. This may occur, for example, when cardinality, popularity and complexity (and any domain-specific discriminators) fail to resolve the dominant / non-dominant association. Or in other examples, both associations may be broken in the later-generated runtime model artifacts, but persisted as non-dominant associations.

Regardless of the exact manner by which the cycles map generator **806** determines dominance in a cycle of the information model, the cycles map generator may capture it in a cycles map **808.** That is, the cycles map generator may create a cycles map that for each cycle in the information model, identifies a non-dominant association of a second or later object to a first object. These non-dominant associations may include respective containment objects for removal and replacement with object qualifiers.

The object registry generator **810** may create an object registry map **812** that identifies the non-dominant association of the second or later object to the first object

(and perhaps any association of the second or later object to one or more other objects of the information model), and includes one or more lifecycle policies for a second or later instantiable object for the respective second or later object. These lifecycle policies may include, for example, one or more constraints on quantity and/or aging policies. These aging policies may be used for the purpose of optimal destruction of an object when not needed, which may be traded against computational penalties with creation (e.g., time to generate a new object), maintenance (e.g., memory) and/or destruction (e.g., garbage collection). In various examples, the object registry map **812** may only maintain unique object UIDs (e.g., GUIDs), and in these examples, the object registry map may also manage unique object count. Duplicate instances of an object UID may be managed by the object reference manager **814.**

The runtime code generator **816** may generate runtime model artifacts for an information model based on the information model, cycles map **808,** object registry map **812,** and perhaps input from the object reference manager **814.** The runtime code generator may preprocess the model using cycles persisted in the cycles map to identify and create object qualifiers for object registry keys. The runtime model artifacts may include an instantiable information model having a plurality of instantiable objects for respective ones of the objects of the information model, various ones of which may include the object qualifiers. The runtime model artifacts may also include an object registry for accessing referenced objects based on the object qualifiers. Duplicate instances of objects managed by the object reference manager may be passed to the runtime code generator, which in one example, may limit the number of instances of a referenced object in accordance with an appropriate cardinality value.

FIG. 9 illustrates runtime model artifacts **900** according to one example implementation. As shown, the artifacts may include an instantiable information model with instantiable objects **902** in a targeted compilable or executable language, and an object registry **904** responsible for the management and instantiation of referenced objects within the instantiable information model. Various ones of the model's instantiable objects may include object qualifiers **906** to the object registry. And the object registry may include an object manager **908,** factory **910** and obj ect registry map **912** (e. g., obj ect registry map **812).**

The object manager **908** may be configured to implement the proxy pattern, responsible for maintaining instances of the referenced objects throughout the object lifecycle. The object manager may be responsible for the instantiation (creation), inter-object access (life) and destruction (death) of objects. If a primary object (one that has been determined to either contain no cycles or as been designated as the dominant object/node) requests the creation of a non-dominant object, the object manager may manage creation (or reuse) of the non-dominant object.

The factory **910** may be configured to implement the factory method pattern, and may be used by the object manager **908** for instantiation of referenced objects. In one example, the factory may be configured to implement the factory method pattern according to the singleton pattern to restrict instances of the referenced pattern according to a cardinality value. And through use of the object registry map **912,** the object manager may manage instantiable object lifecycle policies - determining creation, reuse and/or destruction in relation to a requirement dictated by the cycles map **808** and rules governing non-dominant object identification and flattening.

Instantiable objects **902** with object qualifiers **906** for non-dominant associations may use manager accessor methods along with the object qualifier to request an instance of a respective referenced object. When a referenced object needs to be instantiated as a containment object (member of an existing, instantiable parent object), the existing parent object may use an object manager accessor method. This method may accept an object qualifier as an input parameter and return the instantiated referenced object. If the instantiated referenced object already exists, the existing instantiated referenced object may be returned (cardinality values may influence the number of new referenced objects that may be instantiated).

In accordance with example implementations, in instances in which a modified DAG is required to represent associations between instantiable model objects **902,** the runtime model artifacts **900** may differ from traditional automatically-generated instantiable model objects in a number of different manners. Cyclic model references removed in the creation of a DAG-based model may be reconstituted in the instantiable model and expressed as an object qualifier of type *string.* Objects with object-registry associations may possess a GUID, and perhaps also cardinality value.

At runtime, the object registry **904** may manage non-dominant associations based on pre-computed cardinality values, and the object registry map **912** contained within the object registry. In an instance in which an instantiable object **902** requests access to a referenced object, it may present an object accessor key including the object qualifier *string* object to the object registry. Referenced objects may be instantiated by the object registry when necessary and returned to the respective instantiable object. The object registry may manage a backward reference by returning the original object rather than instantiating a new object. In this manner, the runtime model artifacts **900** of example implementations need not compromise removing the backward-facing associations, the inverse node.

According to example implementations of the present disclosure, the model-management system **400** and its subsystems including the code-generation system **402** may be implemented by various means. Similarly, the example of a code-generation system **800,** including each of its respective elements, may be implemented by various means according to example implementations. Means for implementing the systems, subsystems and their respective elements may include hardware, alone or under direction of one or more computer program code instructions, program instructions or executable computer-readable program code instructions from a computer-readable storage medium.

In one example, one or more apparatuses may be provided that are configured to function as or otherwise implement the systems, subsystems and respective elements shown and described herein. In examples involving more than one apparatus, the respective apparatuses may be connected to or otherwise in communication with one another in a number of different manners, such as directly or indirectly via a wireline or wireless network or the like.

Generally, an apparatus of exemplary implementations of the present disclosure may comprise, include or be embodied in one or more fixed or portable electronic devices. Examples of suitable electronic devices include a smartphone, tablet computer, laptop computer, desktop computer, workstation computer, server computer or the like. The apparatus may include one or more of each of a number of components such as, for example, a processor (e.g., processor unit) connected to a memory (e.g., storage device).

The processor is generally any piece of hardware that is capable of processing information such as, for example, data, computer-readable program code, instructions or the like (generally "computer programs," e.g., software, firmware, etc.), and/or other suitable electronic information. More particularly, for example, the processor may be configured to execute computer programs, which may be stored onboard the processor or otherwise stored in the memory (of the same or another apparatus). The processor may be a number of processors, a multi-processor core or some other type of processor, depending on the particular implementation. Further, the processor may be implemented using a number of heterogeneous processor systems in which a main processor is present with one or more secondary processors on a single chip. As another illustrative example, the processor may be a symmetric multi-processor system containing multiple processors of the same type. In yet another example, the processor may be embodied as or otherwise include one or more application-specific integrated circuits (ASICs), field-programmable gate arrays (FPGAs) or the like. Thus, although the processor may be capable of executing a computer program to perform one or more functions, the processor of various examples may be capable of performing one or more functions without the aid of a computer program.

The memory is generally any piece of hardware that is capable of storing information such as, for example, data, computer programs and/or other suitable information either on a temporary basis and/or a permanent basis. The memory may include volatile and/or non-volatile memory, and may be fixed or removable. Examples of suitable memory include random access memory (RAM), read-only memory (ROM), a hard drive, a flash memory, a thumb drive, a removable computer diskette, an optical disk, a magnetic tape or some combination of the above. Optical disks may include compact disk - read only memory (CD-ROM), compact disk - read/write (CD-R/W), DVD or the like. In various instances, the memory may be referred to as a computer-readable storage medium which, as a non-transitory device capable of storing information, may be distinguishable from computer-readable transmission media such as electronic transitory signals capable of carrying information from one location to another. Computer-readable medium as described herein may generally refer to a computer-readable storage medium or computer-readable transmission medium.

In addition to the memory, the processor may also be connected to one or more interfaces for displaying, transmitting and/or receiving information. The interfaces may include a communications interface (e.g., communications unit) and/or one or more user interfaces. The communications interface may be configured to transmit and/or receive information, such as to and/or from other apparatus(es), network(s) or the like. The communications interface may be configured to transmit and/or receive information by physical (wireline) and/or wireless communications links. Examples of suitable communication interfaces include a network interface controller (NIC), wireless NIC (WNIC) or the like.

The user interfaces may include a display and/or one or more user input interfaces (e.g., input/output unit). The display may be configured to present or otherwise display information to a user, suitable examples of which include a liquid crystal display (LCD), light-emitting diode display (LED), plasma display panel (PDP) or the like. The user input interfaces may be wireline or wireless, and may be configured to receive information from a user into the apparatus, such as for processing, storage and/or display. Suitable examples of user input interfaces include a microphone, image or video capture device, keyboard or keypad, joystick, touch-sensitive surface (separate from or integrated into a touchscreen), biometric sensor or the like. The user interfaces may further include one or more interfaces for communicating with peripherals such as printers, scanners or the like.

As indicated above, program code instructions may be stored in memory, and executed by a processor, to implement functions of the systems, subsystems and their respective elements described herein. As will be appreciated, any suitable program code instructions may be loaded onto a computer or other programmable apparatus from a computer-readable storage medium to produce a particular machine, such that the particular machine becomes a means for implementing the functions specified herein. These program code instructions may also be stored in a computer-readable storage medium that can direct a computer, a processor or other programmable apparatus to function in a particular manner to thereby generate a particular machine or particular article of manufacture. The instructions stored in the computer-readable storage medium may produce an article of manufacture, where the article of manufacture becomes a means for implementing functions described herein. The program code instructions may be retrieved from a computer-readable storage medium and loaded into a computer, processor or other programmable apparatus to configure the computer, processor or other programmable apparatus to execute operations to be performed on or by the computer, processor or other programmable apparatus.

Retrieval, loading and execution of the program code instructions may be performed sequentially such that one instruction is retrieved, loaded and executed at a time. In some example implementations, retrieval, loading and/or execution may be performed in parallel such that multiple instructions are retrieved, loaded, and/or executed together. Execution of the program code instructions may produce a computer-implemented process such that the instructions executed by the computer, processor or other programmable apparatus provide operations for implementing functions described herein.

Execution of instructions by a processor, or storage of instructions in a computer-readable storage medium, supports combinations of operations for performing the specified functions. It will also be understood that one or more functions, and combinations of functions, may be implemented by special purpose hardware-based computer systems and/or processors which perform the specified functions, or combinations of special purpose hardware and program code instructions.

Many modifications and other implementations of the disclosure set forth herein will come to mind to one skilled in the art to which this disclosure pertains having the benefit of the teachings presented in the foregoing descriptions and the associated drawings. Therefore, it is to be understood that the disclosure is not to be limited to the specific example implementations provided herein and that modifications and other implementations are intended to be included within the scope of the appended claims. Moreover, although the foregoing descriptions and the associated drawings describe example implementations in the context of certain example combinations of elements and/or functions, it should be appreciated that different combinations of elements and/or functions may be provided by alternative implementations without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

## Claims

1. A model-management system (400) that includes a code-generation system (402), comprising:
a cycles map generator (806) configured to traverse an information model having a plurality of objects at least some of which form a cycle, the cycles map generator (806) being configured to create a cycles map (808) that, for the cycle, identifies a non-dominant association of a second or later object to a first object;
an object registry generator (810) configured to create an object registry map (812) that identifies the non-dominant association and includes one or more lifecycle policies for a second or later instantiable object for the respective second or later object; and
a runtime code generator (816) configured to generate an instantiable information model and object registry (904) based on the information model, cycles map (808) and object registry map (812),
wherein generation of the instantiable information model includes generation of a plurality of instantiable objects (902) for respective ones of the objects of the information model, including generation of the second or later instantiable object that, for the non-dominant association, includes an object qualifier (906),
wherein the runtime code generator (816) is configured to generate the second or later instantiable object including a contained first instantiable object, and then remove the contained first instantiable object and replace it with the object qualifier (906) that identifies a referenced object for the first object to be instantiated through the object registry (904), instead of a contained first instantiable object to be instantiated from within the second or later instantiable object, to thereby break the cycle nature generated by the association created in the model while maintaining the relationship between objects.

2. The model-management system (400) of Claim 1, wherein the object qualifier (906) is used as a key to access the referenced object through an object registry.

3. The model-management system (400) of Claim 1, wherein the first object is related to the second object through a dominant association, and the second or later object is related back to the first object through the non-dominant association, and
wherein generation of the instantiable objects (902) includes generation of the first instantiable object that, for the dominant association, contains the second instantiable object for instantiation from therewithin.

4. The model-management system (400) of Claims 1 - 3, wherein the runtime code generator (816) is configured to generate the instantiable information model using a plurality of object-oriented design patterns including a proxy pattern and factory (910) method pattern, and
wherein the object registry (904) generated by the runtime code generator (816) includes an object manager (908) configured to implement the proxy pattern to manage instantiation of the referenced object, and an object factory (910) configured to implement the factory (910) method pattern to instantiate the referenced object.

5. The model-management system (400) of Claim 4, wherein the object-oriented design patterns further include a singleton pattern, and
wherein object factory (910) is configured to implement the factory (910) method pattern according to the singleton pattern to restrict instances of the referenced pattern according to a cardinality value.

6. The model-management system (400) of Claims 1 - 5 further comprising:
a model repository (802) configured to store one or more information models at least some of which are removable according to a weighted first-in-first-out technique, the cycles map generator (806) being configured to receive the information model from the model repository (802).

7. The model-management system (400) of Claims 1 - 6 further comprising:
an adapter component (804) configured to convert the information model from any of a plurality of different formats to a common format in which the information model is traversed.

8. A method for code generation, comprising:
traversing an information model having a plurality of objects at least some of which form a cycle, and creating a cycles map (808) that, for the cycle, identifies a non-dominant association of a second or later object to a first object;
creating an object registry map (812) that identifies the non-dominant association and includes one or more lifecycle policies for a second or later instantiable object for the respective second or later object; and
generating an instantiable information model and object registry (904) based on the information model, cycles map (808) and object registry map (812),
wherein generation of the instantiable information model includes generation of a plurality of instantiable objects (902) for respective ones of the objects of the information model, including generation of the second or later instantiable object that, for the non-dominant association, includes an object qualifier,
wherein generating the instantiable information model includes generating the second or later instantiable object including the contained first instantiable object, and then removing the contained first instantiable object and replacing it with the object qualifier that identifies a referenced object for the first object to be instantiated through the object registry (904), instead of a contained first instantiable object to be instantiated from within the second or later instantiable object, to thereby break the cycle nature generated by the association created in the model while maintaining the relationship between objects.

9. The method of Claim 8, wherein the object qualifier (906) is used as a key to access the referenced object through an object registry.

10. The method of Claim 8, wherein the first object is related to the second object through a dominant association, and the second or later object is related back to the first object through the non-dominant association, and
wherein generation of the instantiable objects (902) includes generation of the first instantiable object that, for the dominant association, contains the second instantiable object for instantiation from therewithin.

11. The method of Claims 8 - 10, wherein the instantiable information model is generated using a plurality of object-oriented design patterns including a proxy pattern and factory (910) method pattern, and
wherein the object registry (904) includes an object manager (908) configured to implement the proxy pattern to manage instantiation of the referenced object, and an object factory (910) configured to implement the factory (910) method pattern to instantiate the referenced object.

12. The method of Claim 11, wherein the instantiable information model is generated using the plurality of object-oriented design patterns further including a singleton pattern, and
wherein object factory (910) is configured to implement the factory (910) method pattern according to the singleton pattern to restrict instances of the referenced pattern according to a cardinality value.

13. The method of Claims 8 - 12 further comprising:
receiving the information model for traversal from a model repository (802) configured to store one or more information models at least some of which are removable according to a weighted first-in-first-out technique.

14. The method of Claims 8 - 13 further comprising:
converting the information model from any of a plurality of different formats to a common format in which the information model is traversed.
